Europäisches Patentamt

European Patent Office

Office européen des brevets

(11) Publication number: **0 422 824 A1**

# EUROPEAN PATENT APPLICATION

(21) Application number: 90310817.3

(22) Date of filing: 03.10.90

(51) Int. Cl.⁵: **H01L 21/336**

(30) Priority: 12.10.89 US 420420

(43) Date of publication of application:
**17.04.91 Bulletin 91/16**

(84) Designated Contracting States:
**DE FR GB IT**

(71) Applicant: **AMERICAN TELEPHONE AND
TELEGRAPH COMPANY
550 Madison Avenue
New York, NY 10022(US)**

(72) Inventor: Lee, **Kuo-Hua**
**1308 Country Club Road**
Wescosville, Pennsylvania 18106(US)
Inventor: **Lu, Chih-Yuan**
**5371 Andrea Drive**
**Wescosville, Pennsylvania 18106(US)**
Inventor: **Sung, Janmye**
**1109 Barnside Road**
**Wescosville, Pennsylvania 18103(US)**

(74) Representative: Watts, Christopher Malcolm
Kelway et al
**AT&T (UK) LTD. AT&T Intellectual Property
Division 5 Mornington Road
Woodford Green Essex IG8 OTU(GB)**

(54) **Field-effect transistor with polysilicon window pad.**

(57) A field-effect transistor is described which has the gate(5) close to a window pad used for the source/drain contacts. The gate structure(5) has insulating sidewall spacers(13) and an insulating top layer(11). A conductive polysilicon layer(15) is formed between the gate(5) and the field oxide(3). A patterned dielectric layer(23) permits contacts to be made source/drain regions(19) through the polysilicon layer(15). The raised source/drain structure permits easy fabrication of shallow junctions and also permits salicide formation without any junction leakage.

FIG. 4

## FIELD-EFFECT TRANSISTOR WITH POLYSILICON WINDOW PAD

### Technical Field

This invention relates to integrated circuits having field-effect transistors and to methods for making integrated circuits having such transistors.

### Background of the Invention

As the demand for ever-more complex integrated circuits continues to increase, there is a continuing need to reduce the dimensions of the individual components of the integrated circuits to permit increased device packing density. For field-effect transistors, this need includes reductions not only of the dimensions of the channel but also of the areas of the source and drain regions.

One such approach to reducing device dimensions is described in U.S. Patent 4,453,306 issued on June 12, 1984 to William T. Lynch and Frederick Vratny. Device fabrication begins with formation of a multi-level gate electrode having layers of a conductor, insulator, and a silicide-forming metal sequentially deposited on an insulating layer. Standard deposition and patterning techniques are used. A layer of polysilicon is blanket deposited over the entire structure, and a heat treatment forms the silicide on the gate structure. A selective etch removes the silicide from the gate and leaves the polysilicon aligned with respect to both the source and drain regions and extending over the field oxide. Windows, over the field oxide, are formed in a blanket deposited dielectric layer for contacts to both the source and drain regions through the silicide.

However, the windows are typically spaced further from the gate electrode than are the source and drain regions; this spacing reduces the device packing density as compared to that attainable if the windows were over the source and drain regions. One approach to reducing the window to source and drain region spacing, and thus moving the window closer to the gate, is described in U.S. Patent 4,844,776 filed on December 4, 1987, issued on July 4, 1989, and entitled, "Folded Extended Window Field-Effect Transistor." The device is commonly referred to by the acronym FEWMOS. This application is hereby incorporated by reference. The FEWMOS device is also described in IEEE Electron Device Letters pp. 388--390, August 1988. In fabricating this device, a conductive layer, termed a "window-pad layer," is formed over at least a portion of the source and drain regions. However, the gate electrode and the sidewall spacers are insulating on at least on their top surfaces; and, as a result, the window-pad layer need not be precisely aligned with respect to the source and drain regions but can overlap onto the sidewall spacers and the gate, as well as the field oxide. A dielectric layer is deposited after the window pad layer has been formed by patterning a deposited conducting layer, and the dielectric layer is then patterned to form openings which expose at least a portion of the window pad layer. Metal is then deposited within the windows to form the electrical contacts. The structure described permits the spacings between the source and drain to gate regions, as well as the dimensions of source and drain regions themselves, to be small as compared to those in the conventional field-effect transistor structure. The openings which are used to contact the source and drain regions may be substantially above the source and drain regions, or even closer to the gate than are the source and drain regions; i.e., the window-to-gate spacing is approximately equal to or less than that of the source and drain-to-gate-spacing. However, definition of the window pad requires a mask level.

### Summary of the Invention

We have found a method of fabricating an integrated circuit having at least one field-effect transistor by forming field oxide regions and a gate electrode structure having an insulating top layer and insulating sidewalls, the gate structure is located between field oxide regions; depositing a polysilicon layer that covers both the gate structure and the field oxide, and etching back the polysilicon until at least the top surfaces of the gate electrode and the field oxide are exposed, thereby forming a polysilicon window pad layer which extends between the sidewalls and the field oxide. In a preferred embodiment, a dielectric is deposited and patterned to form opening which expose portions of the window pad layer and a metal is deposited in the openings for the electrical contacts to the transistor.

The transistor thus has a gate electrode structure with an insulating top layer and insulating sidewall spacers and source and drain regions on opposite sides of the gate structure. There is a field oxide adjacent to the source and drain regions and polysilicon layer which extends between the sidewall spacer and the field oxide. The window pad layers for adjacent transistors are separated from each other by the intervening field oxide, and the window pad layers for the source and drain regions of one transistor are separated from each

2

other by the gate electrode structure. The etchback insures that these separations exist.

## Brief Description of the Drawing

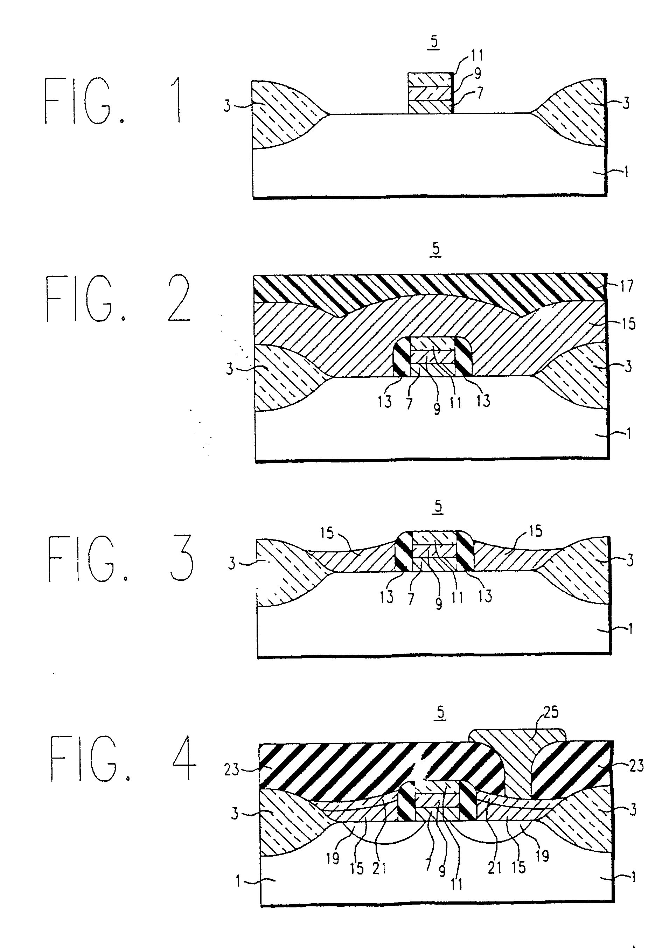

FIGS 1--4 illustrate steps in fabrication of field-effect transistors according to this invention. For reasons of clarity, the elements of the structures depicted are not drawn to scale.

## Detailed Description

An exemplary method of fabricating an integrated circuit, which includes a field-effect transistor, according to this invention will be described by reference to FIGS. 1--4. Depicted in FIG. 1 are substrate 1, and disposed thereon, are field-oxide 3 and gate structure 5. The field oxide regions are spaced from the gate structure, which has polysilicon layer 7, layer 9, which may be oxide or silicide and silicon nitride $SiN_x$ layer 11. The elements depicted are fabricated by techniques that are well known to those skilled in the art and which, therefore, need not be described in further detail. In particular, appropriate layer thicknesses will be readily selected by those skilled in the art as all considerations are well-known. The gate structure and the field oxide should desirably have approximately the same height, as measured from the substrate surface, although this requirement is not absolutely critical if the difference between oxide and/or nitride and polysilicon etch rates is large. That is, a later step etches back a deposited polysilicon layer to expose both the gate and the field oxide without excessive etching of either the gate top layer or the field oxide. Over-etching of either of these elements is limited if they have approximately the same height. However, this height limitation is not critical if the etch used has a relatively high selectivity between oxide or nitride, and polysilicon. Also, the silicon nitride layer can be omitted if only a single dielectric layer is desired on the gate structure. If desired, ion implantation for a lightly doped drain structure may be performed.

Referring now to FIG. 2, sidewall spacers 13 are formed on the sides of the gate electrode structure. The sidewall spacers, which are insulating, may be formed either by, e.g., thermal oxidation or oxide chemical vapor deposition followed by an anistropic etchback. An etching step desirably follows the thermal oxidation step to ensure that the spacers have a small lateral dimension.

A polysilicon layer 15 is deposited and resist 17 spun on. The polysilicon is deposited to a thickness which fills in the space between the gate structure and the field oxide and covers these features. Any conventional polysilicon deposition technique, such as, low-pressure chemical vapor deposition (LPCVD), may be used to deposit the polysilicon. The polysilicon deposits in a conformal manner and need not be deposited in a thick layer.

Conventional and well-known techniques are now used to etch the polysilicon back until the top surfaces of the field oxide 3 and the gate electrode 5 are exposed. At this point, the etching is terminated and a polysilicon window pad layer 15 remains which extends to both the gate structure and the field oxide and thus covers the region between those elements. By exposing the top of the gate, the etch separates the source and drain polysilicon window pad layers from each other. The field oxide separates the window pad layers of adjacent transistors from each other. Both the field oxide 3 and either the oxide 9 or nitride 11 on top of the gate are natural etch stops for the polysilicon etch. The etching selectivity between the oxide or nitride and polysilicon should be sufficiently high so that overetching into the oxides is not a problem. The resulting structure is depicted in FIG. 3.

Selective ion implantation is now performed with conventional techniques to dope the polysilicon. Both NMOS and PMOS devices may be formed. After ion implantation, the dopants are driven into the source and drain areas by conventional and well-known heat treatments to form source and drain regions 19. The field oxide is adjacent to the source/drain regions. Very shallow, e.g., 100nm to 150nm, source and drain junctions below the silicon surface are easily obtained. Alternatively, elevated source/drain regions can be formed. "Elevated" means that a significant portion of the source/drain region is above the electrical channel. If salicide source and drain regions are needed, the salicide 21 can be formed on source and drain window pads 15 using well-known techniques. For example, a silicide forming transition metal is deposited after the window pad layers are formed and heated to form the silicide. It should be noted that the polysilicon and metal thicknesses can be selected so that the salicide does not extend into the source/drain regions. Source/drain junction leakage is, therefore, not a problem.

A passivation dielectric 23 is deposited and windows are opened in the dielectric for the metallizations 25. These steps are performed using conventional and well-known techniques. The completed device is depicted in FIG. 4. Those skilled in the art will readily appreciate that an integrated circuit comprises many such interconnected devices.

Several observations can now be made about the process described and the device constructed. As compared with the FEWMOS structure previously discussed, one mask level is eliminated from the fabrication process. Variations in the structure depicted, and, in the method described will be readily thought of by those skilled in the art.

## Claims

1. A method of fabricating an integrated circuit having at least one field-effect transistor comprising the steps of:
forming field oxide regions(3) on a substrate(1);
forming a gate electrode structure(5) having an insulating top layer(11) and insulating sidewalls(13) on said substrate(1), said structure being located between said field oxide regions(3);
depositing polysilicon(15), said polysilicon(15) covering said gate structure(5) and said field oxide(3);
etching back said polysilicon(15) at least until the top surfaces of said field oxide(3) and of said gate electrode structure(5) are exposed, and said polysilicon(15) forming a window pad layer which extends between the sidewall spacers(15) and the field oxides(3).
2. A method as recited in claim 1 comprising the further steps of:
depositing a dielectric(23) over said substrate(1) after said etching back step;
patterning said dielectric(23) to form openings which expose portions of said window pad layer; and,
depositing a metal(25) in said openings.
3. A method as recited in claim 2 in which said gate electrode structure(5) and said field oxide(3) have approximately the same height.
4. A method as recited in claim 1 comprising the further step of doping said polysilicon layer(15).
5. A method as recited in claim 4 comprising the further step of:
heating to drive said dopants into said substrate.
6. A method as recited in claim 1 further comprising the step of forming a silicide on said window pad layers.

FIG. 1

FIG. 2

FIG. 3

FIG. 4

European
Patent Office

**EUROPEAN SEARCH
REPORT**

Application Number

**EP 90 31 0817**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | RESEARCH DISCLOSURE, no. 303, July 1989, page 496, New York, US; ANONYMOUS: "Method for making devices having reduced field gradients at junction edges" * Whole document * | 1,4-6 | H 01 L 21/336 |
| X | EP-A-0 233 791  (SGS MICROELETTRONICA SpA) * Abstract; column 4, line 30 - column 5, line 37; figures 6-9 * | 1,4,5 | |
| Y | | 2,3,6 | |
| D,Y | IEEE ELECTRON DEVICE LETTERS, vol. 9, no. 8, August 1988, pages 388-390, New York, US; C.-Y. LU et al.: "A folded extended window MOSFET for VLSI applications" * Page 389, figure 1; abstract * | 2,3,6 | |
| A | EP-A-0 121 351  (OKI ELECTRIC INDUSTRY CO.) | | |
| D,A | EP-A-0 319 215  (AMERICAN TELEPHONE AND TELE-GRAPH) | | |

TECHNICAL FIELDS
SEARCHED (Int. Cl.5)

H 01 L

The present search report has been drawn up for all claims

| Place of search | Date of completion of search | Examiner |
|---|---|---|
| The Hague | 18 December 90 | GELEBART Y.C.M. |